# EUROPEAN PATENT APPLICATION

(11) **EP 1 968 099 A1**
(43) Date of publication of application: **10.09.2008**
(21) Application number: 07250655.3
(22) Date of filing: 16.02.2007
(51) Int. Cl.: H01J 37/32, C23C 16/40, C23C 16/511, C23C 16/448

(54) **Thin film deposited on a substrate and deposition system for such thin film**

(71) Applicant: Mikuro Denshi Corporation Limited, Kawagoe-shi, Saitama-ken (JP)
(72) Inventor: Takizawa, Tsutomu c/o Mikuro Denshi Corporation Limited, Saitama-ken (JP); Nakayama, Takamichi c/o Mikuro Denshi Corporation Limited, Saitama-ken (JP); Kashiwagi, Kunihiro, Shiki-shi, Saitama-ken (JP); Sakamoto, Yuichi, Tachikawa-shi Tokyo-to (JP)
(74) Representative: Calderbank, Thomas Roger

(57) **Abstract**

The present invention aims to provide a ZnO thin film deposited substrate and a thin film deposition system exhibiting a specific resistance sufficiently reduced to be useful for transparent electrodes of a liquid crystal display, characterized in that Zn material evaporated and oxidized by microwave oxygen plasma to the compound ZnO which is, in turn, deposited on the substrate and thereby the thin film is formed, and the ZnO thin film deposited on the substrate is exposed to microwave hydrogen plasma so as to reduce a specific resistance of the ZnO thin film and thereby to modify this ZnO thin film to electrically conductive thin film.

## Description

The present invention relates to a thin film substrate having thin film of ZnO deposited on a substrate surface under oxidizing effect of oxygen plasma and then exposed to hydrogen plasma so as to be converted to electrically conductive thin film and a deposition system such thin film.

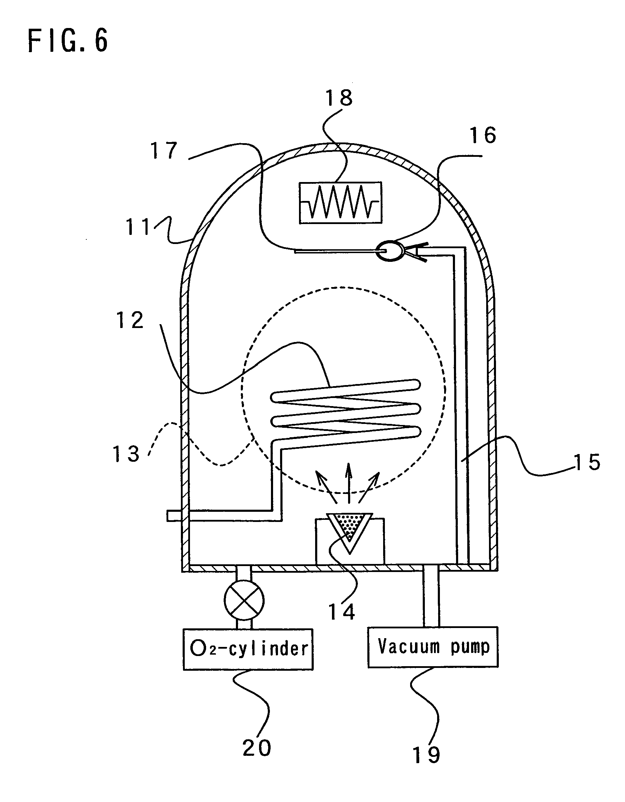

Conventionally, various types of deposition system for thin film of zinc oxide (ZnO) are available, one example of which is illustrated by Fig. 6 of the accompanying drawings.

Fig. 6 is a diagram schematically illustrating a RF deposition system.

As illustrated, this RF deposition system is adapted to energize a coil antenna 12 provided within a chamber 11 from a radio frequency power source RF in the order of 13. 56 MHz and thereby to cause the coil antenna 12 to generate oxygen plasma 13.

This RF deposition system is further provided in a lower region within the chamber 11 with an evaporation source (i.e., evaporation means) 14 adapted to evaporate zinc (Zn) material as the material to be deposited in the form of thin film.

The evaporation source 14 is provided in the form of a conductive container loaded with Zn material so that this container is resistance heated and evaporates the Zn material loaded therein as the conductive container is supplied with electric current.

The chamber 11 further includes therein an inverted L-shaped column support 15 adapted to hold a glass substrate 17 in a horizontal position above the oxygen plasma via a retainer 16 provided on a distal end of the column support 15.

The glass substrate 17 is evenly heated by a substrate heating device 18 provided in an upper region of the chamber 11.

Such RF thin film deposition system is usually operated in a manner that the chamber 11 is depressurized by a vacuum pump 19 while the chamber 11 is supplied with gaseous oxygen from O₂-cylinder 20.

In the RF thin film deposition system, Zn material evaporated under resistance heating by the evaporation source 14 is oxidized by the oxygen plasma 13 and deposited on the glass substrate 17 in the form of ZnO so that transparent thin film is formed on the glass substrate 17.

The transparent thin film has been effectively utilized to produce various devices such as surface wave device, piezoelectric thin film and band-pass filter.

Optically, the ZnO thin film formed in the manner as has been described above has a relatively high light transmission in the order of 81%. Electrically, however, such ZnO thin film is an insulator (for example, having a specific resistance of 1×10¹³Ω/cm² and a film thickness of 200µm).

In view of this, such ZnO thin film is certainly useful as the electrically insulating transparent thin film but has been unable to be utilized as electrically conductive material in the form of transparent thin film (for example, transparent electrodes in liquid crystal display).

As a typical measure conventionally taken to overcome the restriction as has been described above, ZnO thin film containing Al(aluminum) or Ga(gallium) has been developed so as to reduce the specific resistance of this ZnO thin film. However, a processing equipment to obtain the desired ZnO thin film containing Al or Ga has become excessively complicate and the number of parameters used to control this equipment has correspondingly increased. Consequentially, the cost for making the thin film deposition has become too high to be practically accepted.

In view of the current condition as has been described above, it is a preferred aim of the present invention to provide a substrate for ZnO thin film deposition having a low electric resistance and a thin film deposition system allowing the thin film to be easily deposited on the substrate.

The object set forth above is achieved, according to a first aspect of the present invention, by a thin film deposition system characterized in that a transparent thin film deposited substrate having compound ZnO deposited thereon is exposed to hydrogen plasma so as to reduce a specific resistance of the transparent thin film and thereby to modify this transparent thin film to the electrically conductive thin film.

According to a second aspect, the present invention provides the thin film deposition system characterized in that the transparent thin film deposited substrate is exposed to microwave hydrogen plasma and thereby modified to the electrically conductive thin film.

According to a third aspect, the present invention provides the thin film deposition system characterized in that Zn material is exposed to the microwave oxygen plasma to form the transparent thin film deposited substrate having compound ZnO deposited thereon and subsequently this transparent thin film deposited substrate is exposed to microwave hydrogen plasma so as to modify this transparent thin film to the electrically conductive thin film.

According to a fourth aspect, the present invention provides a thin film deposition system characterized in that a transparent thin film deposited substrate having compound ZnO thereon is exposed to hydrogen plasma to reduce a specific resistance of the transparent thin film and thereby to modify this transparent thin film to the electrically conductive thin film.

According to a fifth aspect, the present invention provides the thin film deposition system characterized in that the transparent thin film deposited substrate is obtained by steps of evaporating Zn material as material of the thin film, and exposing the evaporated Zn material to microwave oxygen plasma thereby to deposit compound ZnO on the substrate.

According to a sixth aspect, the present invention provides a thin film deposition system comprising an oxygen plasma generating means serving to supply a depressurized chamber with microwave power and gaseous oxygen to generate microwave oxygen plasma, hydrogen plasma generating means serving to supply the depressurized chamber with microwave power and gaseous hydrogen to generate microwave hydrogen plasma, evaporation means provided with in the depressurized chamber to evaporate Zn material used as material for thin film deposition, and substrate positioned within the depressurized chamber so as to be heated by the microwave oxygen plasma, the thin film deposition system being characterized in that microwave oxygen plasma is generated so that the Zn material evaporated and oxidized by the microwave oxygen plasma to the compound ZnO may be deposited on the substrate and thereby forms the thin film, and microwave hydrogen plasma is generated as an alternative to the oxygen plasma to which the ZnO thin film deposited on the substrate is exposed so as to reduce a specific resistance of the ZnO thin film and thereby to modify this ZnO thin film to electrically conductive thin film.

According to a seventh aspect, the present invention provides the thin film deposition system characterized in that the plasma generating means comprise the microwave windows provided within the depressurized chamber on its bottom and the evaporation means provided within the depressurized chamber on its bottom at the same level as the microwave windows or within the depressurized chamber at a level higher than the microwave windows.

As has been aforementioned, the thin film deposited substrate according to the first aspect of the present invention is obtained by exposing the transparent thin film deposited substrate having the compound ZnO deposited thereon to the hydrogen plasma to reduce the specific resistance of this transparent thin film.

In this way, the ZnO thin film can be made electrically conductive under a surface modifying effect of the hydrogen plasma and thereby the conductive transparent thin film deposited substrate can be obtained.

In view of such modification, the transparent thin film deposited substrate obtained according to the present invention is useful as electrodes and/or circuits, for example, in the liquid crystal display.

When the thin film deposited substrate is used as a transparent component such as a transparent electrode, the substrate on which the compound ZnO is to be deposited must be transparent.

To form the thin film deposited substrate according to the present invention, microwave hydrogen plasma may used as in the second aspect or microwave oxygen plasma may be used together with microwave hydrogen plasma as in the third aspect.

Although ITO electrode has conventionally been used extensively as such transparent electrode, this ITO electrode disadvantageously contains indium which is not only toxic but also scarce substance. Consequentially, the ITO electrode has necessarily required a cost which is practically acceptable. This problem can be satisfactorily solved by the transparent thin film deposited substrate as has been described above.

The transparent thin film deposited substrate is useful also for the other fields such as anti-clouding window glass of car, ETC radio shielding plate for fast highway, anti-theft plate glass, electrodes and/or circuits of flat display, car antenna, solar cell and LED.

The thin film deposition system according to the fourth aspect of the present invention is similar to the system according the fifth aspect of the present invention in that the Zn material is evaporated and exposed to microwave oxygen plasma to produce the compound ZnO which is, in turn, deposited on the substrate.

However, it should be understood that the transparent thin film deposited substrate can be also formed by the FR thin film deposition system previously described above as an example of the prior art without relying on the thin film deposition system according to the fifth aspect of the present invention.

As the substrate on which the compound ZnO is deposited, materials such as glass and synthetic resin can be used.

The thin film deposition system according to the sixth aspect of the present invention adopts the process comprising steps of depositing the compound ZnO on the substrate and modifying the deposited ZnO thin film to be electrically conductive.

Specifically, in the case of this thin film deposition system, microwave power and gaseous oxygen are supplied to the depressurized chamber to generate microwave oxygen plasma.

Subsequently, the Zn material to be deposited in the form of thin film is evaporated and exposed to oxygen plasma to produce the compound ZnO which is, in turn, deposited on the substrate.

Then, supply of gaseous oxygen is shut off and thereupon gaseous hydrogen is supplied to the depressurized chamber to generate microwave hydrogen plasma within this depressurized chamber.

As a result, the ZnO thin film is converted from the insulating thin film to electrically conductive thin film and thereby the electrically conductive substrate can be obtained.

The thin film deposition system according to the seventh aspect of the present invention is provided with the evaporation means located at the level same as or higher than the microwave windows so that the evaporated Zn material and/or the compound ZnO might not directed to the microwave windows (e.g., made of quartz glass).

In other words, the microwave windows (e.g., made of quartz glass) is reliably protected from the evaporated Zn material and/or the compound ZnO.
In the drawings:
Fig. 1 is a diagram schematically illustrating a thin film deposition system according to a first embodiment of the present invention.
Fig. 2 is a characteristic graph plotting the irradiation time of hydrogen plasma versus a change in the specific resistance of the ZnO thin film.
Fig. 3 is a characteristic graph plotting the crystallinity of the ZnO.
Fig. 4 is a diagram schematically illustrating a thin film deposition system according to a second embodiment of the present invention which is adapted to continuously deposit thin film on a plurality of glass substrates.
Fig. 5 is a diagram schematically illustrating a thin film deposition system according to a third embodiment of the present invention.
Fig. 6 is a diagram schematically illustrating a thin film deposition system of prior art.

Details of the present invention will be more fully understood from the description of the particular embodiments given hereunder in reference with the accompanying drawings.

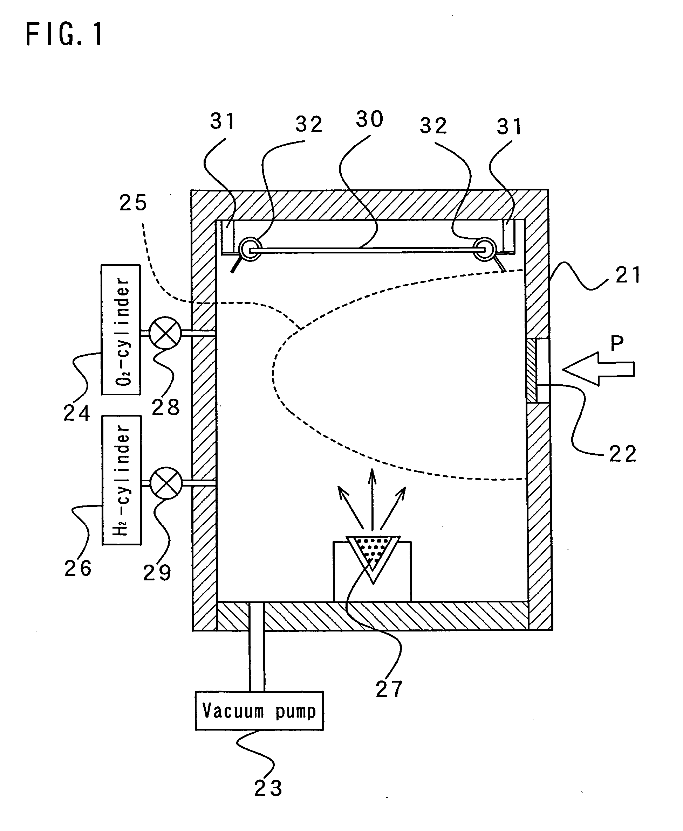

Fig. 1 is a diagram schematically illustrating a thin film deposition system according to a first embodiment of the present invention.

This thin film deposition system is provided on one side of a chamber 21 with a microwave window 22 through which microwave power P is supplied into the chamber 21.

According to this embodiment, the microwave window 22 made of quartz glass and microwave power P oscillated from a microwave source is guided by a wave guide tube through the microwave window so as to irradiate the inside of the chamber 21.

This embodiment further includes a vacuum pump 23 used to depressurize the inside of the chamber 21, an O₂ cylinder 24 from which gaseous oxygen is supplied into the chamber 21 so as to generate oxygen plasma 25 within the chamber 21 and a H₂ cylinder 26 from which gaseous hydrogen is supplied into the chamber 21 so as to generate microwave hydrogen plasma within the chamber 21.

It should be noted that the plasma is generated in the form of microwave surface wave.

In the accompanying drawings, reference numeral 27 designates an evaporation source (evaporation means) of well known art, reference numerals 28, 29 designate valves located in the supply conduit, reference numeral 30 designates a glass substrate, and reference numerals 31 and 32 designate a support column and a retainer, respectively, both for the glass substrate.

The thin film deposition system as has been described above is operated in a manner that the inside of the chamber 21 is irradiated with the microwave power P and gaseous oxygen is supplied into the chamber 21 from the O₂ cylinder 24 while supply of gaseous hydrogen from the H₂ cylinder 26 is shut off so as to generate the microwave oxygen plasma 25 within the chamber 21.

Consequently, the Zn material evaporated from the evaporation source 27 is oxidized by the oxygen plasma 25 and compound ZnO generated as a result of such oxidization is deposited on the glass substrate 30. In this manner, transparent thin film is formed on the glass substrate 30.

Subsequently, supply of gaseous oxygen from the O₂ cylinder 24 is shut off and gaseous hydrogen is supplied from the H₂ cylinder 26 into the chamber 21 so as to generate microwave hydrogen plasma within the chamber 21.

The transparent thin film of the compound ZnO deposited on the glass substrate 30 is now exposed to the hydrogen plasma and a specific resistance of the ZnO thin film is reduced under a surface modifying effect of the hydrogen plasma. In this way, the electrically conductive thin film deposited substrate is obtained.

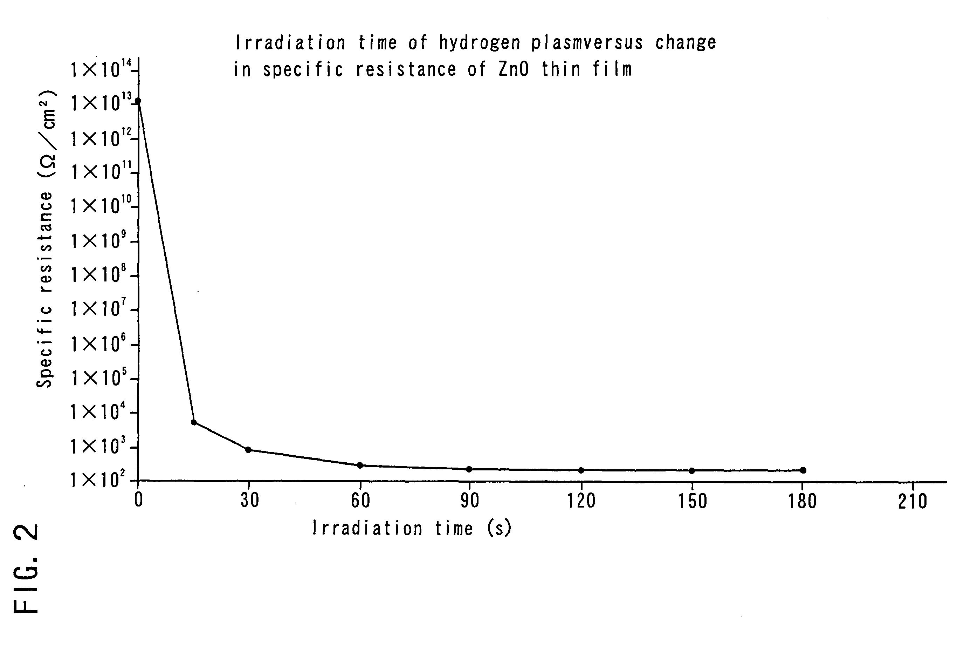

Fig. 2 is a characteristic graph plotting the irradiation time versus the change in specific resistance of the ZnO thin film.

According to this embodiment, the ZnO thin film having a thickness in the order of 200(µm) was formed. As will be apparent from the characteristic graph of Fig. 2, irradiation of the hydrogen plasma for about 1 minute (60 seconds) significantly decreased the specific resistance from 10¹³ units down to 10² units.

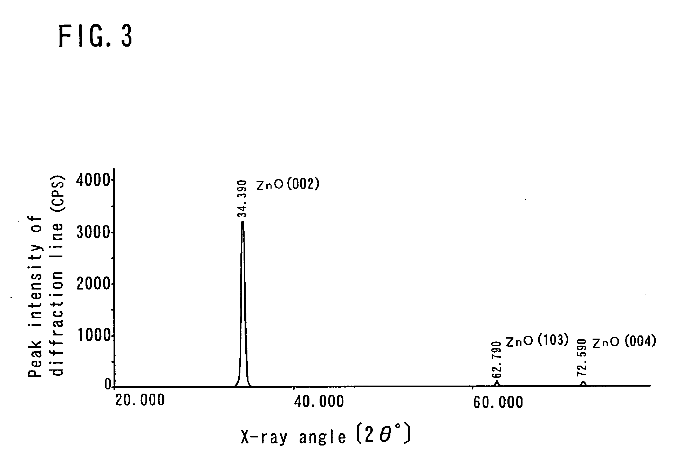

Fig. 3 is a characteristic graph plotting a result obtained by XRD (X-ray diffraction instrument) of the ZnO thin film formed according to this embodiment.

In this characteristic graph, abscissa axis indicates the angle at which the X-ray irradiates the sample of ZnO thin film and ordinate axis indicates the peak intensity of the diffraction line.

It was found from this characteristic graph that this ZnO thin film has three peaks of the diffraction line, in other words, this ZnO thin film is a polycrystalline thin film having three crystalline structures.

It has been also found that the ZnO thin film produced according to this embodiment exhibits a light transmission as high as 97(%) and λ=550(nm).

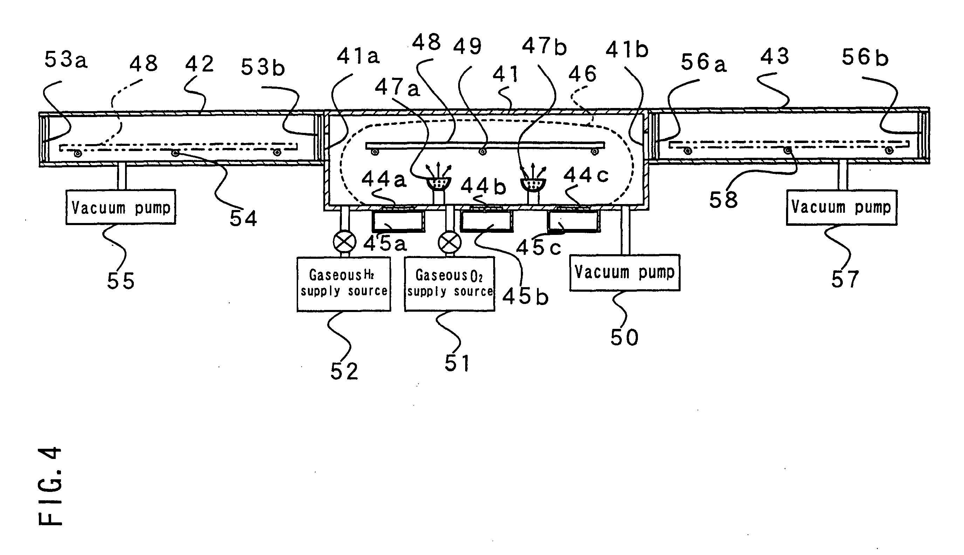

Fig. 4 is a diagram schematically illustrating a thin film deposition system according to a second embodiment of the present invention.

According to this second embodiment, a plurality of the glass substrates may be successively fed into the chamber to ensure that electrically conductive thin film is deposited successively on the respective glass substrates.

The thin film deposition system according to this embodiment is provided on the side of an inlet 41a to the chamber 41 with a front auxiliary chamber 42 and on the side of an outlet 41b from the chamber 41 with a rear auxiliary chamber 43.

The chamber 41 is provided on its bottom with a plurality of microwave windows 44a, 44b, 44c. The microwave power P is supplied via waveguides 45a, 45b, 45c underlying the microwave windows 44a, 44b, 44c, respectively, into the chamber 41 through these windows so that a wide range of the surface wave oxygen plasma 46 and then of the surface wave hydrogen plasma may be generated within the chamber 41.

The chamber 41 further includes a plurality of evaporation sources 47a, 47b from which the Zn material is evaporated upward.

The glass substrate 48 is fed into the chamber 41 by feed rollers 49 adapted to be to-and-fro rotated so as to ensure that the glass substrate 48 can be reciprocated over a short range before the ZnO thin film is completed.

The chamber 41 further comprises a vacuum pump 50 for depressurization and gas supply sources 51, 52 for gaseous O₂ and gaseous H₂, respectively.

The front auxiliary chamber 42 includes shutters 53a, 53b provided at the in- and outlet for the glass substrate 48, respectively, so that the glass substrate 48 may be fed into the front auxiliary chamber 42 with the shutter 53b closed and with the shutter 53 opened. Specifically, the glass substrate 48 is fed into the front auxiliary chamber 42 by feed rollers 54 as indicated by a chain double-dashed line in Fig. 4.

Immediately after the glass substrate has been fed into the front auxiliary chamber 42, the shutter 53a is closed and then the front auxiliary chamber 42 is depressurized by the vacuum pump 55.

Then the shutter 53b is opened and the glass substrate 48 is fed from the front auxiliary chamber 42 into the chamber 41 as indicated by a solid line in Fig. 4 to initiate a process for ZnO thin film deposition.

This process for ZnO thin film deposition comprises steps of generating the oxygen plasma 46, depositing the compound ZnO on the substrate 48 to form the ZnO thin film and then generating hydrogen plasma to make this ZnO thin film electrically conductive.

The rear auxiliary chamber 43 is provided at the in- and outlets for the glass substrate 48 with shutters 56a, 56b, respectively, in the similar manner to that in the case of the front auxiliary chamber 42.

This rear auxiliary chamber 43 is depressurized by a vacuum pump 57 when the glass substrate 48 having the thin film deposited thereon is discharged from the chamber 41. Then the shutter 56a is opened to feed the glass substrate 48 into the rear auxiliary chamber 43 by means of feed rollers 49, 58.

Immediately after the glass substrate 48 has been fed into the rear auxiliary chamber 43 as indicated by a chain double-dashed line in Fig. 4, the shutter 56a is closed and then the shutter 56b is opened to discharge the glass substrate 48 from the rear auxiliary chamber 43.

According to this embodiment, the glass substrate 48 is conveyed through the front auxiliary chamber 42, the chamber 41 and the rear auxiliary chamber 43 so that the electrically conductive ZnO thin film may be deposited thereon. Such arrangement allows the thin film to be successively deposited on a plurality of the glass substrate, on one hand, and allows the thin film deposition to be achieved even on the glass substrate which has a relatively large area, on the other hand.

By locating the evaporation sources at a level higher than the microwave windows as in this second embodiment, it can be reliably avoided that the evaporated Zn material and the compound thereof ZnO might cling to the microwave windows.

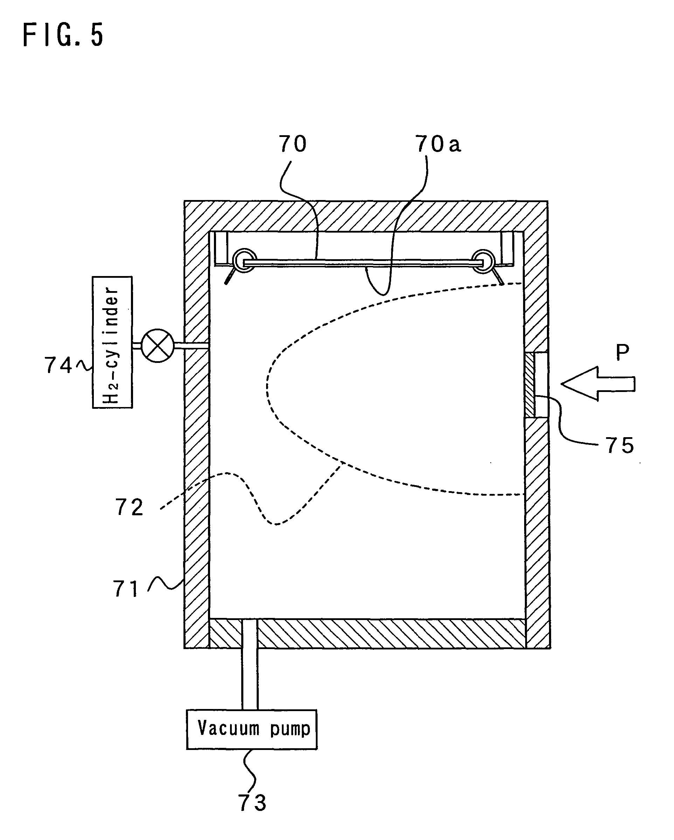

Fig. 5 is a diagram schematically illustrating a thin film deposition system according to a third embodiment of the present invention.

This embodiment is characterized in that, after a transparent thin film deposited substrate 70 having ZnO thin film 70a thereon has previously been produced in the separate system, this transparent thin film deposited substrate 70 is positioned within a chamber 71 and the ZnO thin film is exposed to hydrogen plasma 72 to modify the thin film to the electrically conductive thin film.

Referring to Fig. 5, reference numeral 73 designates a vacuum pump, reference numeral 74 designates a H₂ cylinder, reference letter P designates microwave power and reference numeral 75 designates microwave windows.

While the preferred embodiments of the present invention have been described, it should be understood that the ZnO thin film deposition may be formed without utilization of the microwave oxygen plasma, for example, by the FR thin film deposition system.

The hydrogen plasma used to modify the ZnO thin film to the electrically conductive thin film is not limited to the microwave hydrogen plasma and it is also possible to use, for example, the hydrogen plasma generated by supplying the FR thin film deposition system with gaseous H₂.

## Claims

1. A thin film deposition system **characterized in that** a transparent thin film deposited substrate having compound ZnO deposited thereon is exposed to hydrogen plasma so as to reduce a specific resistance of the transparent thin film and thereby to modify this transparent thin film to the electrically conductive thin film.

2. The thin film deposition system defined by Claim (1), wherein said transparent thin film deposited substrate is exposed to microwave hydrogen plasma and thereby modified to the electrically conductive thin film.

3. The thin film deposition system defined by Claim (1), wherein Zn material is exposed to the microwave oxygen plasma to form said transparent thin film deposited substrate having compound ZnO deposited thereon and subsequently this transparent thin film deposited substrate is exposed to microwave hydrogen plasma so as to modify this transparent thin film to the electrically conductive thin film.

4. A thin film deposition system **characterized in that** a transparent thin film deposited substrate having compound ZnO thereon is exposed to hydrogen plasma to reduce a specific resistance of the transparent thin film and thereby to modify this transparent thin film to the electrically conductive thin film.

5. The thin film deposition system defined by Claim (4), wherein said transparent thin film deposited substrate is obtained by steps of evaporating Zn material as material of the thin film, and exposing the evaporated Zn material to microwave oxygen plasma thereby to deposit compound ZnO on the substrate.

6. A thin film deposition system comprising:
an oxygen plasma generating means serving to supply a depressurized chamber with microwave power and gaseous oxygen to generate microwave oxygen plasma,
hydrogen plasma generating means serving to supply said depressurized chamber with microwave power and gaseous hydrogen to generate microwave hydrogen plasma,
evaporation means provided with in said depressurized chamber to evaporate Zn material used as material for thin film deposition, and
substrate positioned within said depressurized chamber so as to be heated by said microwave oxygen plasma, said thin film deposition system being **characterized in that**:
wherein microwave oxygen plasma is generated so that the Zn material evaporated and oxidized by said microwave oxygen plasma to the compound ZnO may be deposited on said substrate and thereby forms the thin film, and
wherein microwave hydrogen plasma is generated as an alternative to said oxygen plasma to which the ZnO thin film deposited on said substrate is exposed so as to reduce a specific resistance of the ZnO thin film and thereby to modify this ZnO thin film to electrically conductive thin film.

7. The thin film deposition system defined by Claim (6), wherein said plasma generating means comprise the microwave windows provided within the depressurized chamber on its bottom and said evaporation means provided within the depressurized chamber on its bottom at the same level as the microwave windows or within the depressurized chamber at a level higher than the microwave windows.
